(19) Europäisches Patentamt
European Patent Office
Office européen des brevets

(11) **EP 3 772 064 A1**

(12) **EUROPEAN PATENT APPLICATION**

(43) Date of publication:
**03.02.2021 Bulletin 2021/05**

(51) Int Cl.:
***G11C 13/00*** *(2006.01)*     ***G11C 11/16*** *(2006.01)*

(21) Application number: **19189801.4**

(22) Date of filing: **02.08.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Imec VZW**
**3001 Leuven (BE)**

(72) Inventor: **OH, Hyungrock**
**3001 Leuven (BE)**

(74) Representative: **AWA Sweden AB**
**P.O. Box 5117**
**200 71 Malmö (SE)**

(54) **A MEMORY DEVICE AND A METHOD FOR CONFIGURING A MEMORY DEVICE**

(57) According to an aspect of the present inventive concept there is provided a method for configuring a memory device,

the memory device comprising:

a plurality of memory cells, wherein each memory cell comprises a resistive memory element and a bipolar selector connected in series between a respective pair of first and second access lines,

sense amplifier circuitry connected to the plurality of first access lines and/or to the plurality of second access lines, and the method comprising performing a read mode configuration comprising configuring the memory device such that (subsequent to the read mode configuration) each memory cell, when selected to be read, is read in accordance with one of a first and a second read scheme, wherein:

the first read scheme comprises: applying a first read voltage across a selected memory cell, such that a read current of a first polarity is passed through the selected memory cell, and sensing a resistive state of the resistive memory element of the selected memory cell using the sense amplifier circuitry, and

the second read scheme comprises: applying a second read voltage across a selected memory cell, such that a read current of a second polarity opposite to the first polarity is passed through the selected memory cell, and sensing a resistive state of the resistive memory element of the selected memory cell using the sense amplifier circuitry.

*Fig. 2*

EP 3 772 064 A1

## Description

### Technical field

The present inventive concept relates to a method for configuring a memory device. The present inventive concept further relates to a memory device.

### Background

The resistive memory device technology is an enabler for high-density non-volatile data storage. Examples of resistive memory devices include Magnetic Random Access Memory (MRAM), Phase Change RAM (PC-RAM) and resistive RAM (ReRAM). The memory cells of a resistive memory device comprise a resistive memory element connected between a bit line and a word line. The resistive memory elements may be switched between a higher resistance and a lower resistance state by applying appropriate write currents/voltages via the bit line and word lines. The state of a resistive memory element may be read by applying a read voltage to the resistive memory element and sensing the state using a sense amplifier.

In a selector-based resistive memory device, a memory cell is supplemented with a bi-polar selector, connected in series with the resistive memory element between the bit line and the word line. This memory cell is known as the "1S1R" memory cell. The bi-polar selector may block current (i.e. present a high resistance to current) for voltages below a threshold and allow current (i.e. present a low resistance to current) for voltages above the threshold. The bi-polar selector thus enables memory cells with reduced leakage currents as well as selective read and write access.

A further merit of 1S1R memory cells is that they lend themselves for integration in cross-point memory devices. In a cross-point memory device, bit lines and word lines may be arranged in different metal layers / metallization levels, with the memory cells located at the crossings between the bit lines and word lines. This design enables very high density memory arrays.

However, as the performance of the 1S1R memory cell is dependent on not only the properties of the resistive memory element but also of the bipolar selector, they may present an increased sensitivity to process variations. This makes high yield large scale fabrication of devices with desired performance more challenging.

### Summary

An objective of the present inventive concept is to address the challenge of high yield large scale fabrication of memory devices with desired performance. Further and alternative objectives may be understood from the following.

According to a first aspect of the present inventive concept there is provided a method for configuring a memory device,
the memory device comprising:

a plurality of first and second access lines, the plurality of first access lines forming a plurality of bit lines and the plurality of second access lines forming a plurality of word lines, or vice versa,
a plurality of memory cells, wherein each memory cell comprises a resistive memory element and a bipolar selector connected in series between a respective pair of first and second access lines,
sense amplifier circuitry connected to the plurality of first access lines and/or to the plurality of second access lines,

and the method comprising performing a read mode configuration comprising configuring the memory device such that (subsequent to the read mode configuration) each memory cell, when selected to be read, is read in accordance with one of a first and a second read scheme, wherein:

the first read scheme comprises: applying a first read voltage across a selected memory cell, such that a read current of a first polarity is passed through the selected memory cell, and sensing a resistive state of the resistive memory element of the selected memory cell using the sense amplifier circuitry, and the second read scheme comprises: applying a second read voltage across a selected memory cell, such that a read current of a second polarity opposite to the first polarity is passed through the selected memory cell, and sensing a resistive state of the resistive memory element of the selected memory cell using the sense amplifier circuitry.

According to a second aspect, there is provided a memory device comprising:

a plurality of first and second access lines, the plurality of first access lines forming a plurality of bit lines and the plurality of second access lines forming a plurality of word lines (WL), or vice versa,
a plurality of memory cells, wherein each memory cell comprises a resistive memory element and a bipolar selector connected in series between a respective pair of first and second access lines, and sense amplifier circuitry connected to the plurality of first access lines and/or the plurality of second access lines,
wherein the memory device is configured such that each memory cell, when selected to be read, is read in accordance with one of a first and a second read scheme, wherein:

the first read scheme comprises: applying a first read voltage across a selected memory cell, such that a read current of a first polarity is passed through the selected memory cell, and sensing a resistive state of the resistive memory element of the selected memory cell using the sense amplifier circuitry, and

the second read scheme comprises: applying a second read voltage across a selected memory cell, such that a read current of a second polarity opposite to the first polarity is passed through the selected memory cell, and sensing a resistive state of the resistive memory element of the selected memory cell using the sense amplifier circuitry.

It has been realized by the inventor that during read access to a memory cell (i.e. when reading a selected memory cell) there generally exists an optimum sensing polarity with respect to one or more read performance characteristics. That is, a first sensing polarity may allow an improvement over a second opposite sensing polarity with respect to one or more read performance characteristics. "Sensing polarity" here refers to the polarity of the read current supplied to a memory cell or, equivalently, the sign of the read voltage applied across the memory cell. As used herein, the first polarity will be considered to be synonymous to a "positive" sensing polarity, corresponding to a read current flowing from first access line to second access line (and thus to a "positive" read voltage) . Conversely, the second polarity will be considered to be synonymous to a "negative" sensing polarity, corresponding to a read current flowing from second access line to first access line (and thus to a "negative" read voltage).

Based on this insight, the inventive method and device aspects provide a memory device capable of implementing a first read scheme involving a first/positive polarity read current for sensing a resistive state of a selected memory cell, and a second read scheme involving a second/negative polarity read current for sensing a state of a selected memory cell. This allows memory devices to be designed and manufactured in a uniform and common fashion on a large scale, and only subsequently be configured with a desired read scheme. This contrasts conventional technology, wherein the sensing polarity is considered already at the design- and manufacturing-stages. Hence, after manufacturing there is no rational manner of modifying the memory device to use the opposite sensing polarity.

The present inventive concept may advantageously be applied to memory devices of the cross-point type. However, it is envisaged that the present inventive concept has a more general applicability extending to any resistive memory device comprising "1S1R" memory elements.

As used herein, the term "resistive memory element" refers to a non-volatile resistive element configured to be switchable between a first/low resistance state and a second/high resistance state in response to a switching current. Such a current-programmable device is sometimes also referred to as a "memristor".

As used herein, the term "bipolar selector" refers to a two-terminal selector exhibiting a high resistance to current in response to voltages below a threshold (a "non-conducting" or "off" state) and a low resistance to current in response to voltages above the threshold (a "conducting" or "on" state). The selector is bipolar in the sense that it exhibits this behavior for both positive and negative voltages, and may accordingly block or allow a current of either polarity.

The plurality of memory cells may be arranged as an array of memory cells. The array may comprise a plurality of columns (extending along the direction of the first access lines) and rows of memory cells (extending along the direction of the second access lines). Each memory cell may be arranged at a crossing between a respective pair of first and second access lines.

The memory device may comprise control circuitry, wherein the control circuitry may be configured to cause the memory device to operate in accordance with the first or second read scheme during read access to a selected memory cell.

The configuration of the memory device may be achieved in various ways, as will be set out below, both through a structural permanent modification of the memory device (e.g. through fusing) and through programming of the memory device (e.g. by programming of control circuitry).

The memory device may be configured to use a common sensing polarity for each one of the plurality of memory cells. That is, the memory device may (subsequent to the read mode configuration) be configured to read each memory cell (when selected for read) in accordance with the first read scheme (e.g. comprising applying a same first read voltage for any selected memory cell), or to read each memory cell (when selected for read) in accordance with the second read scheme (e.g. comprising applying a same second read voltage for any selected memory cell). Using a common sensing polarity for reading each memory cell may facilitate the read mode configuration. A common sensing polarity may be advantageous in cases where at least a majority of the memory cells exhibit the desired performance for a same sensing polarity. This may occur e.g. when process variations among at least a majority of the memory cells of the memory device are relatively minute.

The memory device may alternatively be configured such that different memory cells may be read using different read schemes. That is, the memory device may (subsequent to the read mode configuration) be configured to read a first subset of said memory cells in accordance with the first read scheme and a second subset of said memory cells in accordance with the second read scheme. A different sensing polarity may be advantageous in cases where memory cells of the first subset and memory cells of the second subset exhibit the desired performance for opposite sensing polarities. This may occur e.g. when process variations among the memory cells of the memory device are relatively great. In case the memory cells are arranged as an array of memory cells, the first and second subsets of memory cells may be formed by memory cells in first and second adjacent regions of the array, respectively. Each memory cell configured to be read in accordance with the first read scheme may be read using a same first read voltage. Each memory cell configured to be read in accordance with the second read scheme may be read using a same second read voltage.

It is envisaged that, for at least a majority of the memory cells, a read margin may be greater when/if read in accordance with one of the first and second read schemes than when/if read in accordance with the other one of the first and second read schemes. The read mode configuration may accordingly comprise configuring at least said majority of memory cells to be read in accordance with said one of the first and second read schemes. In other words, if, for at least a majority of the memory cells, a respective read margin is greater when/if read in accordance with the first read scheme than when/if read with the second read scheme, the memory device may be configured to read at least each memory cell of said majority of memory cells in accordance with the first read scheme. If instead a respective read margin is greater when/if read in accordance with the second read scheme than when/if read with the first read scheme, the memory device may be configured to read at least each memory cell of said majority of memory cells in accordance with the second read scheme.

By "read margin" of a memory cell is meant a metric indicative of a difference between a read current when the resistive memory element of the memory cell is in a high resistance state and when the resistive memory element of the memory cell is in a low resistance state. The read margin may be an important metric for resistive memory devices in that it may be indicative of a robustness of read operation. For instance, a greater read margin may allow data to be read with a reduced risk for read errors.

The read margins may, for two different memory devices, present a different dependence on sensing polarity even if fabricated under similar process conditions, and even if fabricated in parallel on a same wafer. However, in accordance with the inventive method and memory device the sensing polarity may be configured after device fabrication, such that at least a majority of the memory cells may be read in accordance with the read scheme providing the greatest read margin.

It is envisaged that, for a majority of the memory cells ("the majority subset"), a read margin may be greater when/if read in accordance with one of the first and second read schemes and for a remainder of the memory cells ("the non-majority subset") a read margin may be greater when/if read in accordance with the other one of the first and second read schemes. Even in such a case, the memory device may be configured such that each memory cell (i.e. the memory cells of both the majority and the non-majority subsets) is read in accordance with the one of the first and second read schemes providing the greater read margin for the majority subset of memory cells. Hence, the memory device may be configured to use a common sensing polarity for each one of the plurality of memory cells, thus facilitating the read mode configuration while enabling the majority subset of memory cells to be read in accordance with the read scheme providing the greater read margin for the majority subset.

Alternatively, the memory device may be configured such that each memory cell of the majority subset is read in accordance with the one of the first and second read schemes providing the greater read margin for the majority subset of memory cells, and each memory cell of the non-majority subset is read in accordance with the other one of the first and second read schemes. I.e. the read scheme providing the greater read margin for the non-majority subset of memory cells.

The first read scheme may further comprise applying a first access line un-select voltage to first access lines connected to non-selected memory cells and applying a second access line un-select voltage to second access lines connected to the non-selected memory cells. The second read scheme may correspondingly further comprise applying a first access line un-select voltage to first access lines connected to non-selected memory cells and applying a second access line un-select voltage to second access lines connected to the non-selected memory cells. The first access line un-select voltages of the first and second read schemes may be equal, i.e. of equal levels. Moreover, the second access line un-select voltages of the first and second read schemes may be equal. Applying un-select voltages to access lines connected to non-selected ones of the memory cells may reduce leakage currents through the non-selected memory cells, hence improving read reliability. Using first and second un-select voltages of equal level in the first and read schemes may facilitate the read mode configuration.

According to some embodiments of the first aspect the memory device may further comprise control circuitry. The read mode configuration may comprise adapting the control circuitry to control the memory device to operate such that each memory cell, when selected to be read, is read in accordance with the first read scheme or the second read scheme.

The read mode configuration may comprise programming the control circuitry. The programming may comprise programming a state of a mode register of the control circuitry. Read mode configuration via a mode register programming allows a convenient configuration of the memory device, and possibly allows re-programming at a later stage if desired.

Correspondingly, according to some embodiments of the second aspect, the memory device may further comprise control circuitry configured to control the memory device to operate such that each memory cell, when selected for read access, is be read in accordance with one of the first and second read scheme. The control circuitry may comprise a mode register programmed to cause the control circuitry to control the memory device to operate such that each memory cell, when selected, is read in accordance with the first read scheme or the second read scheme.

According to some embodiments of the first aspect, the memory device may comprise control circuitry comprising fuse logic circuitry. The read mode configuration of the memory device may comprise adapting the fuse logic circuitry (e.g. by selectively blowing fuses of the fuse logic circuitry) to cause the control circuitry to control the memory device such that each memory cell, when selected, is in accordance with the first read scheme or the second read scheme.

Correspondingly, according to some embodiments of the second aspect, the memory device may comprise control circuitry comprising fuse logic circuitry adapted to cause the control circuitry to control the memory device to operate such that each memory cell, when selected, is read in accordance with the first read scheme or the second read scheme.

The read currents may be provided by source-sink circuitry of the memory device. More specifically, according to the first read scheme the first read current may be sourced by a first current source via the first access line connected to said selected memory cell and sunk by a first current sink via the second access line connected to said selected memory cell. According to the second read scheme the second read current may be sourced by a second current source via the second access line connected to said selected memory cell and sunk by a second current sink via the first access line connected to said selected memory cell. Read currents of opposite polarities may accordingly be provided by respective current source-sink pairs. The configuration of current sources and sinks may be combined with both "single-" and "double-sided" sense amplifier circuitry:

According to a "single-sided" sense amplifier circuitry implementation, the sense amplifier circuitry may comprise a sense amplifier circuit connected to either the first access lines or the second access lines, wherein both the first read scheme and the second read scheme comprises sensing a resistive state of the resistive memory element of the selected memory cell using the sense amplifier circuit. Hence, a same or common sense amplifier circuit is used during read access regardless of sensing polarity. An amount of circuitry required for reading operation may hence be reduced.

According to a "double-sided" sense amplifier circuitry implementation, the sense amplifier circuitry may comprise a first sense amplifier circuit and a second sense amplifier circuit, the first sense amplifier circuit connected to the plurality of first access lines and the second sense amplifier circuit connected to the plurality of second access lines, or vice versa, and wherein:

the first read scheme may further comprise sensing the resistive state of the resistive memory element of the selected memory cell using the first sense amplifier circuit, and

the second read scheme may further comprise sensing the resistive state of the resistive memory element of the selected memory cell using the second sense amplifier circuit. Hence, a different sense amplifier circuit may be used for the different sensing polarities. In an implementation wherein the memory device may (subsequent to the read mode configuration) is configured to read each memory cell in accordance with the first read scheme, or to read each memory cell in accordance with the second read scheme, the first sense amplifier circuit may be disabled (in case the second read scheme is configured) or the second sense amplifier circuit may be disabled (in case the first read scheme is configured).

A doubled-sided sense amplifier circuitry implementation may provide an increased flexibility for optimizing read operation. This may be particularly advantageous for memory devices comprising non-symmetrical memory arrays, i.e. memory cells arranged in an array having different numbers of rows and columns.

Each one of the above-mentioned sense amplifier circuits (e.g. the "common" sense amplifier circuit, or the first and second sense amplifier circuits) may comprise a plurality of sense amplifiers, each sense amplifier connected to a respective first or second access line. This allows a parasitic capacitance at the input terminal side of the sense amplifier circuitry to be limited. Alternatively, the sense amplifier circuit may comprise a sense amplifier commonly connected to each first access line or each second access line. This allows a total area required by the sense amplifier circuitry to be reduced and may additionally simplify the circuit architecture and the interconnect structure comprising the access lines.

The memory device may comprise a plurality of first and second current sources, each switchably connected to a respective first and second access line, respectively, and a plurality of first and second current sinks, each switchably connected to a respective second and first access line, respectively. This allows a parasitic capacitance at the current source/sink nodes to be limited. Alternatively, the memory device may comprise a common first and a common second current source switchably connected to each of the first and second access lines, respectively, and a common first and a common second current sink switchably connected to each of the second and first access lines, respectively. This allows a total area required by the current source-sink circuitry to be reduced and may additionally simplify the circuit architecture and the interconnect structure comprising the access lines.

The operations of the memory controller of the memory device according to the second aspect may during the read mode be controlled by a programmable mode register of the memory controller. This allows the memory device to be conveniently be configured by programming, and possibly be re-programmed at a later stage if needed.

According to a further aspect, there is provided a memory device configured in accordance with the method of the first aspect, or any afore-mentioned variations thereof.

Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

> Fig. 1 is a schematic illustration of a memory cell.
> Fig. 2 is a schematic illustration of a memory device.
> Fig. 3 is a circuit diagram representation of a memory device during a read mode in accordance with a first read scheme.
> Fig. 4 is a circuit diagram representation of the memory device of Fig. 3 during a read mode in accordance with a second read scheme.
> Fig. 5 is an example timing diagram of signals which may be applied to the various lines of a memory device.
> Fig. 6 is a circuit diagram representation of a variation of a memory device during a read mode in accordance with a first read scheme.
> Fig. 7 is a circuit diagram representation of the memory device of Fig. 5 during a read mode in accordance with a second read scheme.
> Fig. 8 is a circuit diagram representation of a variation of a memory device during a read mode in accordance with a first and second read scheme.
> Fig. 9 is a flow chart of a method for configuring a memory device.

Detailed description

A detailed description of memory devices and methods of configuring memory devices will now be provided with reference to the figures.

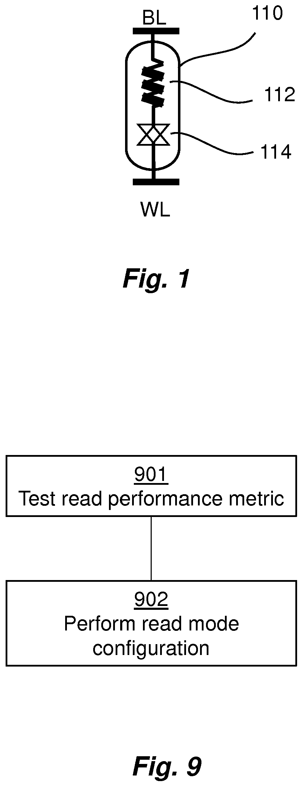

Figure 1 schematically illustrates a 1S1R memory cell 110. The memory cell 110 comprises a resistive memory element 112 and a bipolar selector 114. The resistive memory element 112 and the bipolar selector 114 are connected in series between a word line WL and a bit line BL. As shown in Figure 1, a first terminal of the resistive memory element 112 may be connected to the bit line BL. A second terminal of the resistive memory element 112 may be connected to a first terminal of the bipolar selector 114. A second terminal of the bipolar selector 114 may be connected to the word line WL. However, a reversed order of the element 112 and selector 114 between the word line WL and the bit line BL is also possible, wherein the first terminal of the resistive memory element 112 may be connected to the wordline WL and the second terminal of the bipolar selector 114 may be connected to bit line BL.

The resistive memory element 112 is configured to be switchable between a first resistive state (e.g. a lower resistance state $R_{ML}$) and a second resistive state (e.g. a higher resistance state $R_{MH}$) in response to a switching current. The state of the resistive memory element 112 is maintained in a non-volatile manner, i.e. even in absence of any voltage across the resistive memory element 112.

The bipolar selector 114 remains in the non-conducting / "off" state when an absolute value of a voltage applied across the bipolar selector is lower than a switching threshold $V_{TH}$ of the bipolar selector 114. The bipolar selector 114 switches to the conducting / "on" state when an absolute value of a voltage applied across the bipolar selector exceeds the threshold $V_{TH}$ of the bipolar selector 114. The respective resistance levels provided in the on and off states may differ by several orders of magnitude. As may be appreciated by the skilled person, the resistance level of the off state may typically be several orders of magnitude greater than the resistance $R_{ML}$ and $R_{MH}$ of the resistive memory element 112. Meanwhile, the resistance level of the on state may be of a same or lower order of magnitude than the resistance $R_{ML}$ and $R_{MH}$ of the resistive memory element 112. Thereby, when the bipolar selector 114 is in the off state a majority of a voltage applied across the memory cell 110 may be dropped over the bipolar selector 114. Meanwhile, when the bipolar selector 114 is in the on state at least a major portion of a voltage applied across the memory cell 110 may be dropped over the memory element 112. The threshold $V_{TH}$ at which the bipolar selector switches to the conducting / low-resistance state may typically be set to a level between VSS or 0 V and VDD, preferably closer to VSS than VDD to reduce the operating voltage and power consumption.

In a memory device comprising a plurality of bit lines and word lines and a plurality of memory cells 110 connected between respective pairs of bit lines and word lines, any memory cell may be selected (e.g. for read or write access) by applying a voltage greater than the threshold $V_{TH}$ across the memory cell, via the pair of bit and word lines connected to the selected memory cell, such that the bipolar selector 114 of the selected memory cell is switched to the conducting state. Any other memory cells may remain un-selected by not applying voltages such their respective bipolar selectors switch to the conducting state. When a memory cell 110 is selected for read access, a read voltage may be applied across the memory cell 110. The read voltage may be greater than the threshold $V_{TH}$ and less than a voltage causing switching of a resistive state of the resistive memory element 112 of the memory cell 110 (i.e. the read voltage should not result in writing to the memory cell 110).

Various realizations of the resistive memory elements 112 are possible. In a magnetic random access memory (MRAM) the resistive memory elements may be formed by magnetic tunnel junction devices (MTJs). An MTJ is a magneto-resistive device switchable between two different resistive states (e.g. a parallel "P" state and an anti-parallel "AP" state), providing different amounts of resistance to current. As is known in the art, state switching may be mediated by spin-transfer-torque (STT) and/or spin-orbit-torque (SOT). In the case of SOT-mediated switching the memory element 112 may be provided with an additional pair of terminals (not shown in Figure 1) for the SOT-switching current. Other memristor-based memory technologies include Oxide RAM (OXRAM), Conductive Bridge RAM (CBRAM) and phase-change RAM (PCRAM).

Examples of bipolar selectors 114 include diode-type bipolar selectors such as the mixed ionic-electronic conduction (MIEC) selector, and threshold-type bipolar selectors such as the ovonic threshold switch (OTS), the Chalcogenide Threshold Switch (CTS), and the Threshold Vacuum Switch (TVS), and 2D material based selectors (e.g. graphene or transition metal dichalcogenides such as $MoS_2$).

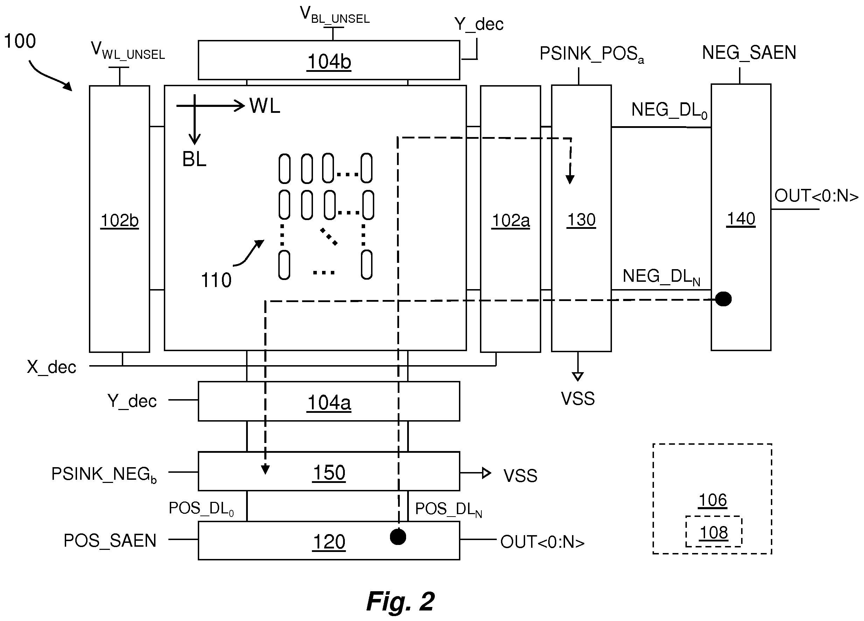

Figure 2 schematically depicts a memory device 100 comprising a plurality of memory cells 110, e.g. such as the memory cell 110 disclosed above and shown in Figure 1. The memory device 100 comprises a plurality of bit lines ("first access lines") extending along bit line or column direction BL. The memory device 100 comprises a plurality of word lines ("second access lines") extending along word line or column direction WL. Although in the following the first access lines are identified as bit lines and the second access lines are identified as word lines, this terminology may be reversed. The memory cells 100 may be arranged in the form of an array, comprising a plurality of rows and columns of bit cells e. g. as shown N+1 rows and N+1 columns. Arrays with different numbers of rows and columns are also possible. The memory device 100 may for example be configured as a cross-point memory device, wherein the bit lines BL and word lines WL may be arranged in different metal layers / metallization levels, with the array of memory cells 110 located at the crossings between the bit lines and word lines.

The memory device 100 comprises sense amplifier circuitry comprising a first sense amplifier circuit 120 connected to the bit lines BL and a second sense amplifier circuit 140 connected to the word lines WL. The first sense amplifier circuit 120 is configured to be enabled when an enable input POS_SAEN is high and otherwise be disabled. Correspondingly, the second sense amplifier circuit 140 is configured to be enabled when an enable input NEG_SAEN is high and otherwise be disabled. The respective outputs OUT<0:N> of the first and second sense amplifier circuits denotes the logic level signals representing data read from the memory cells 110.

The memory device 100 comprises a first current sink circuit 130 connected to the word lines WL and a second current sink circuit 150 connected to the bit lines BL. The first current sink circuit 130 is configured to connect a selected word line $WL_a$ to VSS responsive to a select signal $PSINK\_POS_a$. The second current sink circuit 150 is configured to connect a selected bit line $BL_a$ to VSS responsive to a select signal $PNEG\_POS_b$. The first and second current sink circuit 130, 150 form part of current-source sink circuitry of the memory device 100 which, in use of the memory device 100, is configured to supply read currents and read voltages to the memory cells 110. Figure 2 does not explicitly show first and second current source circuits, corresponding to the first and second current sink circuits, respectively, but are for illustrational simplicity considered to form part of the first and second sense amplifier circuits 120, 140, respectively. During a read mode of the memory device 100, the sense amplifier circuitry and the current source-sink circuitry are configured to cooperate to allow reading of bit cells in accordance with a first or second read scheme, as will be further disclosed below.

The memory device 100 may further comprise additional circuitry such as word line decoder circuitry 102a, 102b and bit line decoder circuitry 104a, 104b, to enable cell selection and pre-charging of word and bit lines. The word line decoder circuitry 102a, 102b and the bit line decoder circuitry 104a, 104b may be responsive to word line and bit line selection signals X_dec and Y_dec, respectively. Pre-charge voltages (in Figure 2 denoted $V_{WL\_UNSEL}$ and $V_{BL\_UNSEL}$) may be provided to the word line and bit line decoder circuitry portions 102b, 104b, respectively, by (not shown) conventional word line and bit line drivers. The operations of the memory device 100, such as during read mode, may be controlled by control circuitry 106 of the memory device 100 configured to provide control signals (e.g. logic signals) for enabling circuit blocks such as the first/second sense amplifier circuits 120, 140, controlling switches of e.g. the source-sink circuitry, the decoder circuitry etc.

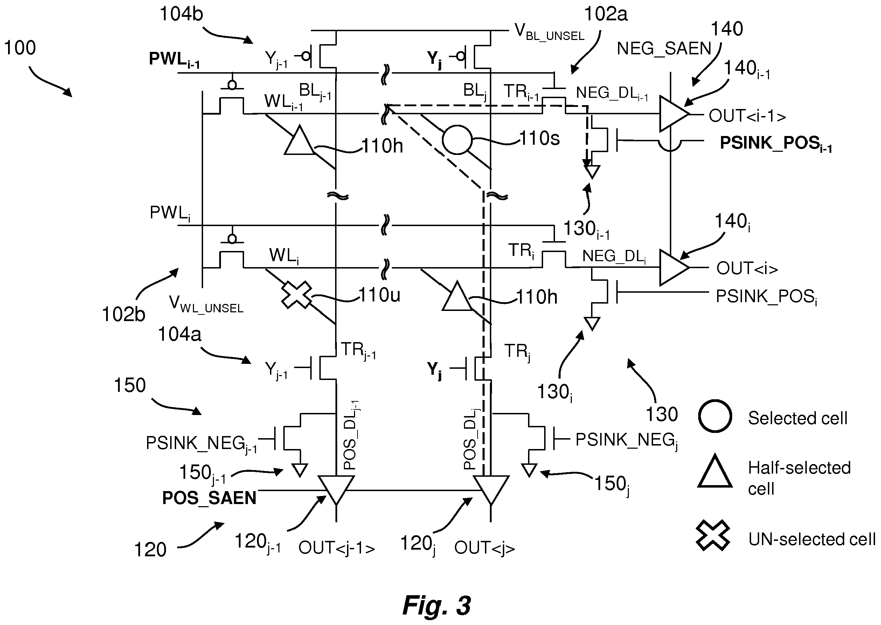

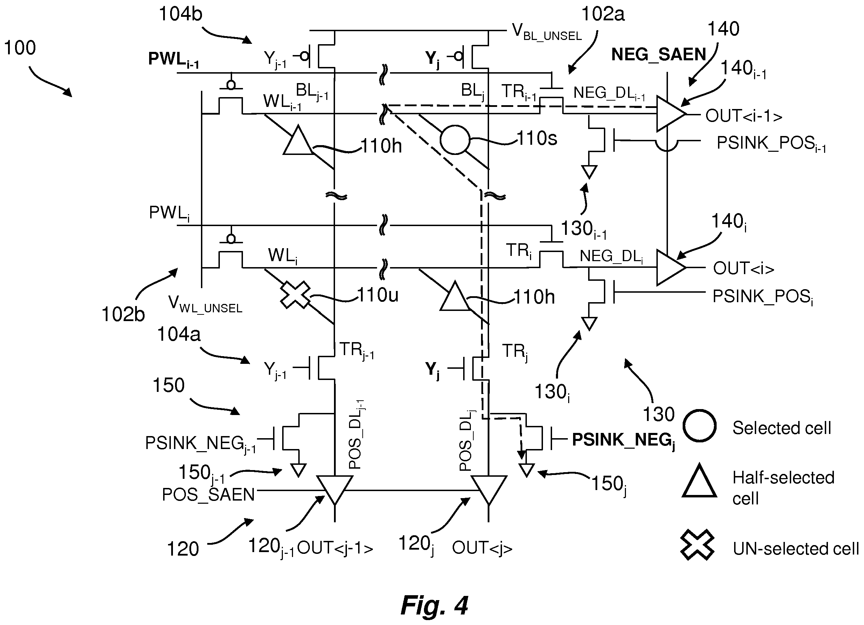

The memory device 100 is configurable to read memory cells 110 in accordance with one of a first and a second read scheme involving opposite sensing polarities, as signified by the two schematically indicated dashed current paths in Figure 2. Read access in accordance with the first read scheme will be described with reference to Figure 3. Thereafter read access in accordance with the second read scheme will be described with reference to Figure 4.

Figure 3 and 4 both depict more detailed circuit diagram representations of the memory device 100, albeit for a subset of the memory cells 110. The first sense amplifier circuit 120 shown in Figures 3 and 4 comprises a plurality of sense amplifiers $120_{j-1}$, $120_j$, each connected to a respective bit line $BL_{j-1}$, $BL_j$. Correspondingly, the second sense amplifier circuit 140 comprises a plurality

of sense amplifiers $140_{i-1}$, $140_i$, each connected to a respective word line $WL_{i-1}$, $WL_i$. Current-mode as well as voltage-mode sense amplifiers are possible. Both single-ended and differential sensing schemes are envisaged. In Figures 3 and 4 (as well as in Figure 2) $POS\_DL_{j-1}$ / $POS\_DL_j$ represent the portions of the bit lines $BL_{j-1}$ / $BL_j$, respectively, located between the decoder circuitry 104a and the first sense amplifier circuit 120. That is, the bit line portions connected to the bit line inputs of the first sense amplifier circuit 120. Correspondingly, $NEG\_DL_i$ / $NEG\_DL_{i-1}$ represent the portions of the word lines $WL_i$ / $WL_{i-1}$, respectively, located between the decoder circuitry 102a and the second sense amplifier circuit 140. That is, the word line portions connected to the word line inputs of the second sense amplifier circuit 140. These portions may also be referred to as first sense lines $POS\_DL_{j-1}$ / $POS\_DL_j$ for the first sense amplifier circuit 120 and second sense lines $NEG\_DL_i$ / $NEG\_DL_{i-1}$ for the second sense amplifier circuit 140.

Each bit line $BL_{j-1}$, $BL_j$ may be switchably connected to the sense amplifier circuit 120 by a respective transistor $TR_{j-1}$, $TR_j$ of the bit line decoder circuitry 104a. Each word line $WL_{i-1}$, $WL_i$ may be switchably connected to the sense amplifier circuit 140 by a respective transistor $TR_{i-1}$, $TR_i$ of the word line decoder circuitry 102a.

The first current sink circuit 130 comprises a plurality of current sinks $130_{i-1}$, $130_i$, each connected to a respective word line $WL_{i-1}$, $WL_i$ via a transistor controllable by a respective sink enable signal $PSINK\_POS_{i-1}$, $PSINK\_POS_i$. Correspondingly, the second current sink circuit 150 comprises a plurality of current sinks $150_{j-1}$, $150_j$, each connected to a respective bit line $BL_{j-1}$, $BL_j$ via a transistor controllable by a respective sink enable signal $PSINK\_NEG_{j-1}$, $PSINK\_NEG_j$.

In Figures 3 and 4, bold-face font may be used indicate high logic level voltages while normal font may be used to indicate low logic level voltages applied during the positive or negative sensing. The terms high logic level voltage and low logic level voltage have their normal meaning within the technical field, i.e. two logical levels or states representing a binary one "1" and a binary zero "0". The high and low logic level signals may be represented by two different voltages. In order to distinguish between a high and low signal, high and low thresholds are specified. When the signal is below the low threshold, the signal is "low" and when above the high threshold, the signal is "high". For sake of simplicity, it may in the following be assumed that a low logic level voltage is 0 V or VSS, while a high logic level voltage is VDD. More generally though, the binary logic input levels for CMOS may be 0V to 1/3 VDD for "low" and 2/3 VDD to VDD for "high".

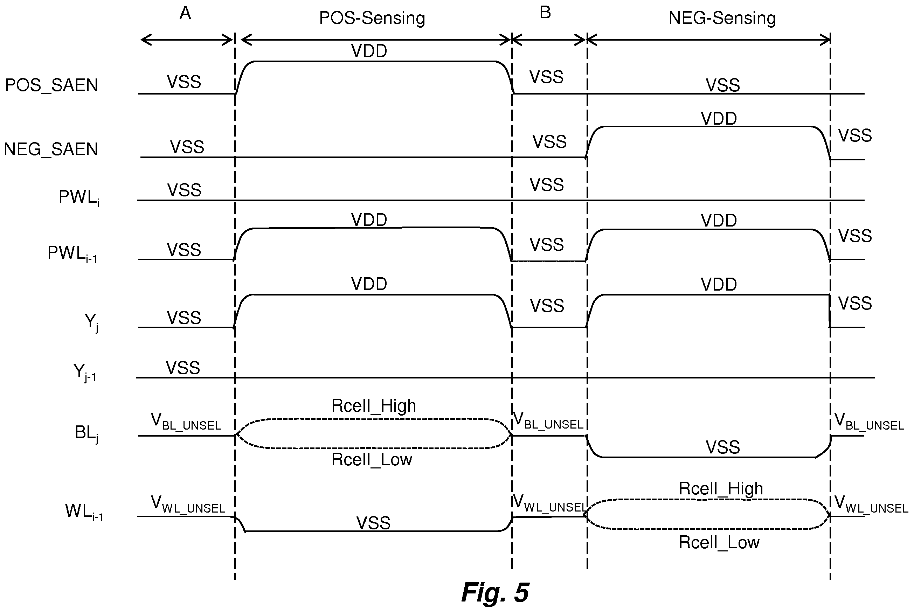

Figures 3 and 4 may be considered in conjunction with Figure 5 schematically showing examples of signals which may be applied in the memory device 100, for implementing the first read scheme ("POS-sensing") and the second read scheme ("NEG-sensing"), respectively.

With reference to Figure 3, the first read scheme comprises applying a first read voltage across a selected memory cell 110s. The first read voltage is such that a read current of a first/positive polarity is passed through the selected memory cell 110s. Hence, (the absolute value of) the first read voltage is set to exceed the switching threshold $V_{TH}$ of the bipolar selector 114 of the selected memory cell 110s. The resistive state of the resistive memory element 112 of the selected memory cell 110s may accordingly be sensed by the first sense amplifier circuit 120, more specifically by the sense amplifier $120_j$. The control circuitry 106 (omitted from Figure 3) may output a high level POS_SAEN (e.g. as shown in Figure 5 VDD) and a low level NEG_SAEN (e.g. VSS) such that the first sense amplifier circuit 120 is enabled while the second sense amplifier circuit 140 is disabled. The control circuitry 106 may further output a high level $PSINK\_POS_{i-1}$ (e.g. VDD) and low level $PSINK\_POS_i$, $PSINK\_NEG_{j-1}$ and $PSINK\_NEG_j$ (e.g. VSS) such that the current sink $130_{i-1}$ is connected to the word line $WL_{i-1}$. The read current may accordingly be sourced by the (current source of) the sense amplifier $120_j$ and sunk by the current sink $130_{i-1}$. The magnitude of the read current, or equivalently the resulting bit line voltage, will depend on the resistive state of the resistive memory element of the selected memory cell 110s and may be sensed by the sense amplifier $120_j$ via the sense line $POS\_DL_i$. The sensed state may be output as a logic level signal OUT<j> (e.g. a high level for a low resistance state and a low level for a high resistance state, or vice versa).

With reference to Figure 4, the second read scheme comprises applying a second read voltage across a selected memory cell 110s. The second read voltage is such that a read current of a second/negative polarity is passed through the selected memory cell 110s. Hence, (the absolute value of) the second read voltage is set to exceed the switching threshold $V_{TH}$ of the bipolar selector 114 of the selected memory cell 110s. The resistive state of the resistive memory element 112 of the selected memory cell 110s may accordingly be sensed by the second sense amplifier circuit 140, more specifically by the sense amplifier $140_{i-1}$. The control circuitry 106 (omitted from Figure 4) may output a high level NEG_SAEN and a low level POS_SAEN such that the second sense amplifier circuit 140 is enabled while the first sense amplifier circuit 120 is disabled. The control circuitry 106 may further output a high level $PSINK\_NEG_j$ and low levels of $PSINK\_NEG_{j-1}$, $PSINK\_POS_{i-1}$ and PSINK_POSi such that the current sink $150_j$ is connected to the bit line $BL_j$. The read current may accordingly be sourced by the (current source of) the sense amplifier $140_{i-1}$ and sunk by the current sink $150_j$. The magnitude of the read current, or equivalently the resulting word line voltage, will depend on the resistive state of the resistive memory element of the selected memory cell 110s and may be sensed by the sense amplifier $140_{i-1}$ via the sense line $NEG\_DL_{i-1}$. The sensed state may be output as a logic level signal OUT<i-1> (e.g. a high level for a low resistance state and a low level for a high resistance state, or vice versa).

The selection of the memory cell 110s may in both read schemes be provided by controlling the switching circuitry 102a, 104a of the bit and word line decoders, e.g. in the illustrated case by providing a high level $Y_j$ and a high level $PWL_{i-1}$ (e.g. VDD as shown in Figure 5).

The first and second read schemes may each comprise pre-charging of the sense line $POS\_DL_i$ or $NEG\_DL_{i-1}$ connected to the selected bit line $BL_j$ or word line $WL_{i-1}$ prior to sensing. The first read scheme may comprise pre-charging the sense line $POS\_DL_i$ to the first read voltage. In response to connecting the sense line $POS\_DL_i$ to the bit line $BL_j$ (e.g. by closing the switch $TR_j$ of the switching circuitry 104a) and connecting the current sink $130_{i-1}$ to the word line $WL_{i-1}$ connected to the selected memory cell 110s, the first read voltage may accordingly be applied across the selected memory cell 110s and a read current may be drawn by the current sink $130_{i-1}$ wherein the resistive state may be sensed by the sense amplifier $120_j$. The second read scheme may comprise pre-charging the sense line $NEG\_DL_{i-1}$ to the second read voltage. In response to connecting the sense line $NEG\_DL_{i-1}$ to the word line $WL_{i-1}$ (e.g. by closing the switch $TR_{i-1}$ of the switching circuitry 102a) and connecting the current sink $150_j$ to the bit line $BL_j$ connected to the selected memory cell 110s, the second read voltage may accordingly be applied across the selected memory cell 110s and a read current may be drawn by the current sink $150_j$ wherein the resistive state may be sensed by the sense amplifier $140_{i-1}$. The magnitude (i.e. absolute value) of the first read voltage (applied in the first read scheme) and the magnitude (i.e. absolute value) of the second read voltage may be equal. This is however not a requirement but it is also contemplated that the magnitudes of the first and second read voltages may be different, for instance depending on the read margins for the different sensing polarities.

It may further be noted that pre-charging also may be applied to memory cells not selected to be read. More specifically, pre-charge voltages set to form so-called "un-select" voltages $V_{BL\_UNSEL}$ and $V_{WL\_UNSEL}$ may be supplied to memory cells not selected to be read. Such non-selected memory cells include half-selected memory cells (indicated by 110h in Figures 3 and 4) represented by memory cells connected to a word line or bit line connected to the selected memory cell 110s. Non-selected memory cells further include memory cells not connected to any word line or bit line connected to the selected memory cell 110s (indicated by 110u in Figures 3 and 4). The un-select voltages may be applied at least to half-selected memory cells 110h, thereby avoiding accidental selection of the same. Un-select voltages may optionally also be applied across un-selected memory cells 110u, thereby avoiding un-defined voltages on associated word and bit lines. The un-select voltages may be set to reduce a voltage across half-selected memory cells 110h, preferably to a magnitude below $V_{TH}$ of the bipolar selectors 114. $V_{BL\_UNSEL}$ and $V_{WL\_UNSEL}$ may as a non-limiting example be set to 1/3VDD or 1/2VDD but the particular level will depend on the threshold voltage $V_{th}$ of the bipolar selectors 114 as well as the first and second read voltage. By supplying a low level signal (e.g. VSS) $Y_{j-1}$ to the decoder circuitry portion 104b during positive or negative sensing, bit lines connected to un-selected and half-selected memory cells 110h, 110u may be biased to the un-select voltage $V_{BL\_UNSEL}$. Correspondingly, by supplying a low level signal (e.g. VSS) $PWL_i$ to the decoder circuitry portion 102b during positive or negative sensing, word lines connected to un-selected and half-selected memory cells 110h, 110u may be biased to the un-select voltage $V_{WL\_UNSEL}$.

As shown in Figure 5, pre-charging of bit lines and word lines may also be provided in "stand-by" periods "A" and "B" preceding sensing. As shown in Figure 5, for all but the selected bit line $BL_j$ and word line $WL_{i-1}$ the pre-charge voltages may be maintained also during the sensing.

Although in Figures 3 and 4, the current sinks of the current sinks of the current sink circuits 130, 150 are shown to be connected to the word lines / bit lines via NMOS transistors, it would in principle be possible to replace the NMOS transistors by PMOS transistors possible provided the logic levels of the enabling signals supplied thereto are inverted. Further, although in Figures 3 and 4 the decoder circuitry portions 102a, 104a are shown to be implemented by NMOS transistors and the decoder circuitry portions 102b, 104b are shown to be implemented by PMOS transistors, the opposite configuration is also possible provided the logic levels of the voltages applied to $Y_{j-1}$, $Y_j$, $PWL_{i-1}$, $PWL_i$, are inverted.

Further, although in Figures 3 and 4, the first sense amplifier circuit 120 is used for sensing according to the first read scheme while the second sense amplifier circuit 140 is used for sensing according to second read scheme, it is also possible to reverse the roles of the sense amplifier circuits 120, 140. That is, the first read scheme may comprise using the second sense amplifier circuit 140 for sensing while the second read scheme may comprise using the first sense amplifier circuit 120 for sensing.

The memory device 100 may be configured to apply a common read scheme for all memory cells 110. I.e. the memory device 100 may be configured such that the first read scheme (involving positive polarity read current) is used for reading each one of the memory cells 110. It is however envisaged that different read schemes may be applied for reading different ones of the memory cells 110. For example, the first read scheme may be used for reading memory cells of a first subset and the second read scheme may be used for reading memory cells of a second subset. The memory cells of the first subset may for example be formed by a first block of memory cells, e.g. located along one edge of the array, and the second subset may be formed by a second non-overlapping block of remaining memory cells, e.g. located along the opposite edge of the array. However, other distributions are also conceivable. In any case, the memory device 100 may be configured to apply the read scheme (or read schemes) by programming the control circuitry 106 accordingly.

The configuration may be performed during a read mode configuration step. The control circuitry 106 may comprise a register 108, such as programmable mode register, wherein the configuration of read scheme may be performed by programming a state of the mode register 108 using a mode register set (MRS) command. More specifically, programming the control circuitry in accordance with the first read scheme may comprise performing a first mode register command on the mode register. Programming the control circuitry in accordance with the second read scheme may comprise performing a second mode register command on the mode register. The first and second mode register commands may be setup to cause the control circuitry to control the memory device such that the read access proceeds in accordance with the first or second read schemes, respectively, when reading a selected memory cell.

Alternatively, or additionally, the read mode configuration may comprise configuring fuse logic circuitry of the control circuitry 106 to cause the control circuitry 106 to control the memory device 100 to operate such that each memory cell, when selected, is read in accordance with the first read scheme or the second read scheme. By way of example, if the memory device 100 is configured to read all memory cells 110 using a same read scheme, the fuse logic may be adapted (e.g. by selectively blowing fuses thereof) such that (in case of configuring the first read scheme) the first sense amplifier circuit 120 always is enabled during the read mode, regardless of the memory cell selected, while the second sense amplifier circuit 140 is permanently disabled. Alternatively, (in case of configuring the second read scheme) the fuse logic may be adapted such that the second sense amplifier circuit 140 always is enabled during the read mode, regardless of the memory cell selected, while the first sense amplifier circuit 120 is permanently disabled.

The selection of which read scheme to configure during the read mode configuration may be made to favor various, potentially competing, read performance characteristics of the memory device 100. An important characteristic of a memory device is the read margin, sometimes also referred to as the sense margin. An improved read margin of a memory cell 110 may imply an improved read robustness in that the different resistive states of the resistive memory element 112 of the memory cell 110 may be more readily distinguished. A read margin metric may for instance be calculated as a ratio *RM:*

$$RM = \frac{I_{ML} - I_{MH}}{I_{ML}}$$

where $I_{ML}$ and $I_{MH}$ are the read current through the memory cell 110 when the resistive memory element 112 thereof is in the lower resistance state ($R_{ML}$) and the higher resistance state ($R_{MH}$), respectively. If the memory cells 110 of the memory device 100 present read margins dependent on the sensing polarity, the memory device 100 may be configured such that at each memory cell 110 may be read in accordance with the read scheme for which the respective read margin for each memory cell is the greater one. In case different memory cells present a maximum read margin for different sensing polarities (i.e. first and second subsets presenting a maximum read margin for a positive and negative sensing polarity, respectively, or vice versa), the memory device 100 may be configured such that each memory cell of the first subset is read in accordance with the first read scheme and each memory cell of the second subset is read in accordance with the second read scheme, or vice versa. Alternatively, if a majority of the memory cells 110 present a maximum read margin for a same sensing polarity, the memory device 100 may be configured such that each memory cell 110 is read in accordance with the read scheme providing the maximum read margin for the majority of the memory cells 110. Assuredly, the non-majority subset of the memory cells 110 may then be read using a sensing polarity which does not provide the optimum read margin. However, since the read margin is maximized for the majority subset this choice may still represent a choice striking a useful comprise between a risk of read errors and a complexity of the read mode configuration.

The dependence of read margin on sensing polarity for the memory device 100 may be determined using indirect as well as direct methods. An example of an indirect method includes simulating read access for memory elements of a known implementation to determine for which sensing polarity a lowest read error rate may be achieved, for instance taking a type of bipolar selector and resistive memory element, access line capacitance, sense amplifier noise margins, reference voltages (e.g. un-select voltages) etc. into account. Another example of an indirect method includes testing the memory device 100 by performing read access to each memory cell 110, for both the lower and higher resistance states, to determine for which sensing polarity a lowest read error rate may be achieved. An example of a direct method includes measuring the read margins for one or more of the memory cells 110, preferably at least for a majority of the memory cells 110. The testing may comprise, for each memory cell 110 to be tested, measuring a first read margin for read currents of the first polarity (i. e. positive read voltages), and a second read margin for read currents of the second polarity (i.e. negative read voltages). Based on a comparison of the read margins measured for the different sensing polarities the read mode of the memory device 100 may be configured in accordance with the first or the second read scheme. The read margins may be measured using a wafer prober, measuring and recording the read margins for both sensing polarities .

It may be advantageous to measure the first and second read margins for each one of the memory cells 110, to increase the data underlying the configuration. A first combined read margin metric may be calculated from the first read margins and a second combined read window margin may be calculated from the first read margins. The read mode of the memory device 100 may be configured to implement the first read scheme if the first combined read margin metric is greater than the second combined read margin metric, or to implement the second read scheme if the second combined read margin metric is greater than the first combined read margin metric. The first combined read margin metric may for instance be an average or a median value of the first read margins measured for the memory cells 110. The second combined read margin metric may for instance be an average or a median value of the second read margins measured for the memory cells 110.

In case the memory device 100 is to be configured to apply different read schemes for reading different ones of the memory cells 110, the configuration may be applied for each one of the memory cells 110 based on a result of the read margin measurements for said one cell.

Examples of other read performance metrics which may be measured in addition to, or instead of, read margins include magnitude of optimum read voltages for the first and second sensing polarities, wherein a higher read voltage may allow higher read performance and a lower read voltage may allow lower power consumption. The read scheme configuration may be performed to favor selected one of these metrics.

The test step may form part of a conventional wafer level test procedure performed at a wafer or package stage following device fabrication. The test procedure may involve also other tests, such as identifying non-working cells, testing write performance, write windows etc. As may be appreciated, in addition to the read mode configuration, the operations of the memory device 100 during write mode may be configured subsequent to the testing, e.g. by setting write voltages, write signal timings etc. Write mode of 1S1R memory devices of the afore-mentioned type is per se known and will not be further described herein.

Figure 9 schematically shows how a read mode configuration step 902 may be preceded by a test step 901 wherein one or more of the memory cells 110 of the memory device 100 may be tested to establish one or more read performance characteristics or metrics of the memory device 100 and the dependence thereof on sensing polarity. It should however be noted that the testing of read performance characteristics is optional and that the choice of read scheme to use for each memory cell may be performed without any preceding steps, for instance based on a priori knowledge of the characteristics of the memory device 100.

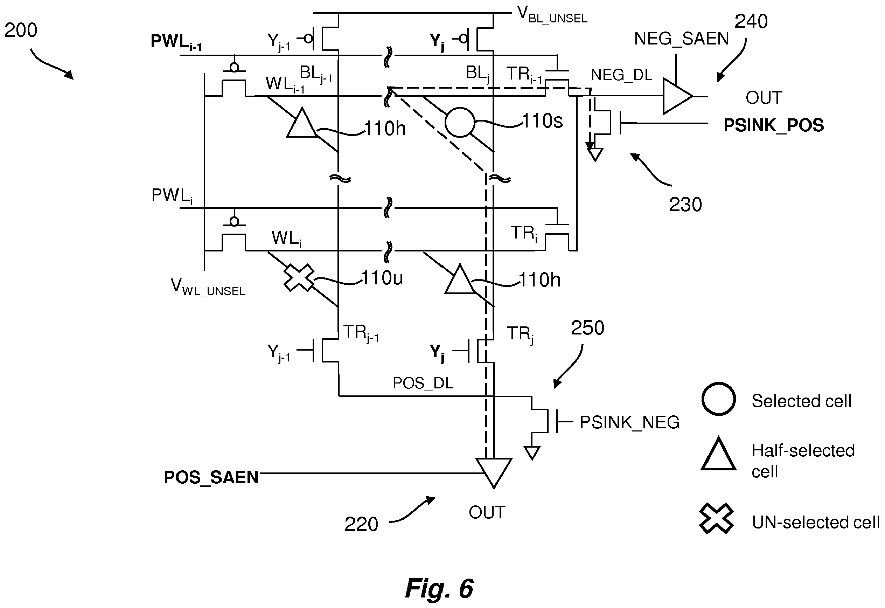

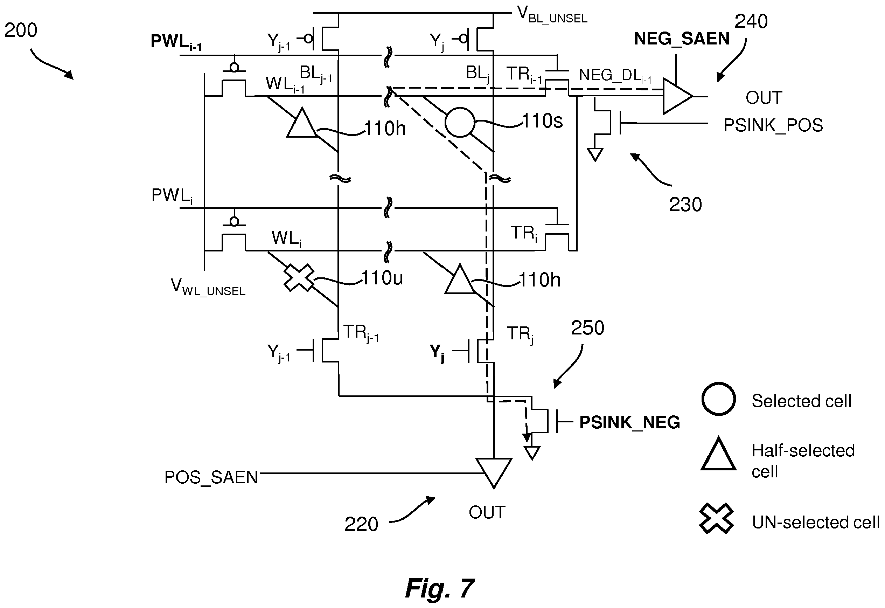

Figures 6 and 7 show a further memory device 200, similar to the memory device 100 however different in that the sense amplifier circuitry comprises a first sense amplifier circuit 220 comprising a single sense amplifier commonly connected to each of the bit lines BL (e.g. the common bit line portion POS_DL). Correspondingly, the sense amplifier circuitry comprises a second sense amplifier circuit 240 comprising a single sense amplifier commonly connected to each of the word lines WL (e.g. the common word line portion NEG_DL). The memory device 200 further comprises a first current sink circuit 230 comprising a single current sink common for each word line WL and a second current sink circuit 250 comprising a single current sink common for each bit line BL. As shown in the figures, the first read scheme (Figure 6) and the second read scheme (Figure 7) may be implemented in a corresponding manner as disclosed above.

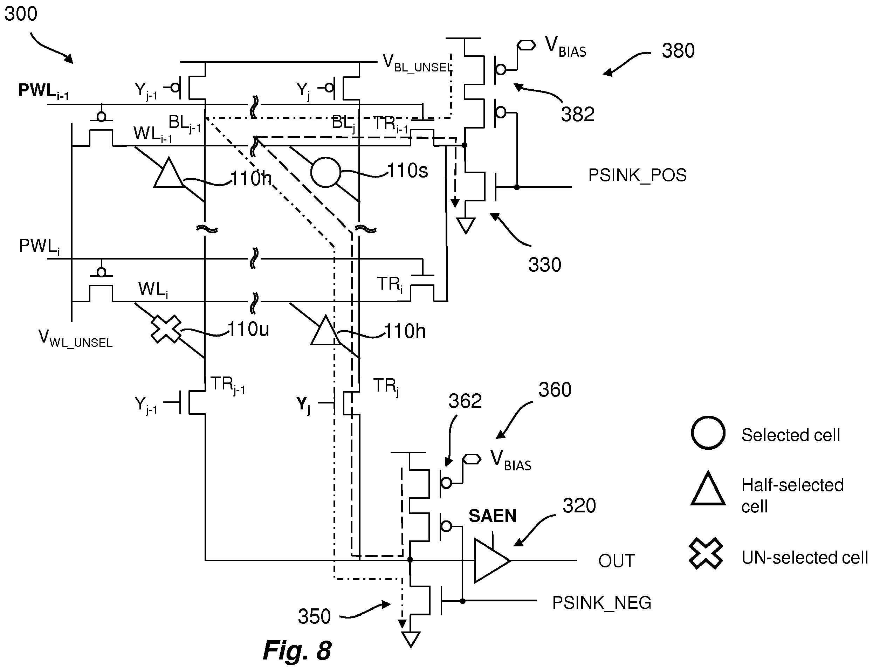

Figure 8 show a further memory device 300, similar to the memory device 200. In contrast to the memory device 200, the memory device 300 comprises one sense amplifier circuit 320 which is used for sensing the resistive state of the selected memory cell 110s, regardless of the sensing polarity. In Figure 8, the sense amplifier circuit 320 is connected to the bit lines BLs (i.e. the bit lines BLs are used as sense lines). However, it is equally possible to instead have the sense amplifier circuit 320 connected to the word lines WLs (i.e. wherein the word lines WLs are used as sense lines). As mentioned above, (single-ended or differential) current-mode as well as voltage-mode sense amplifiers are possible.

Figure 8 further shows current source-sink circuitry of comprising a first current source-sink circuit comprising a first current source 360 and a first current sink 330, and a second current source-sink circuit comprising a second current source 380 and a second current sink 350.

As show in Figure 8, the pair of the first current source 360 and the first current sink 330 and the pair of the second current source 380 and the second current sink 350 are connectable to the selected memory cell 110s in a complementary fashion, to provide a read current of either a first polarity (dashed line) or a second polarity (dashed-dotted line), respectively. The magnitude of the first and second read currents may be controlled via the bias voltage $V_{BIAS}$ applied to the gate of the transistor 362 (for the first polarity) and the gate of the transistor 382 (for the second polarity). The illustrated implementation of the current sources 360, 380 are however but one example and other implementations of controlled current sources are possible, as per se is known in the art. It is also possible to use dedicated DC voltage sources instead of VDD supply voltages.

Hence, the first read scheme may comprise connecting the first current source 360 and the first current sink 330 of the first source-sink circuit to the selected memory cell 110s. This may be achieved by providing a high logic level PSINK_POS (e.g. VDD) and a low logic level PSINK_NEG (e.g. VSS) to the transistors as indicated in Figure 8. Additionally, a high logic level sense amplifier enable signal SAEN (e.g. VDD) may be supplied to the sense amplifier circuit 320. The second read scheme may comprise connecting the second current source 380 and the second current sink 350 of the second source-sink circuit to the selected memory cell 110s. This may be achieved by providing a high logic level PSINK_NEG (e.g. VDD) and a low logic level PSINK_POS (e.g. VSS) to the transistors as indicated in Figure 8. Additionally, a high logic level sense amplifier enable signal SAEN (e.g. VDD) may be supplied to the sense amplifier circuit 320.

In Figure 8, the two current source-sink pairs are shared by the word lines WL and bit lines BL. According to a variation, the memory device 300 may comprise a plurality of first and second current sources. Each first current source may be switchably connected to a respective bit line BL and each second current source may be switchably connected to a respective word line WL. Correspondingly, each first current sink may be switchably connected to a respective word line WL and each second current source may be switchably connected to a respective bit line BL. During read operation, the current source-sink pair connected to the memory cell selected for read may be controlled by the control circuitry to provide the read current of the desired polarity.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A method for configuring a memory device (100, 200, 300),
   the memory device comprising:

   a plurality of first and second access lines, the plurality of first access lines forming a plurality of bit lines (BL) and the plurality of second access lines forming a plurality of word lines (WL), or vice versa,
   a plurality of memory cells (110), wherein each memory cell comprises a resistive memory element (112) and a bipolar selector (114) connected in series between a respective pair of first and second access lines,
   sense amplifier circuitry (120, 140; 220, 240; 320) connected to the plurality of first access lines and/or to the plurality of second access lines,

   and the method comprising performing a read mode configuration comprising configuring the memory device such that thereafter each memory cell, when selected to be read, is read in accordance with one of a first and a second read scheme, wherein:

   the first read scheme comprises: applying a first read voltage across a selected memory cell (110s), such that a read current of a first polarity is passed through the selected memory cell (110s), and sensing a resistive state of the resistive memory element (112) of the selected memory cell (110s) using the sense amplifier circuitry (120, 140; 220, 240; 320, 340), and
   the second read scheme comprises: applying a second read voltage across a selected memory cell (110s), such that a read current of a second polarity opposite to the first polarity is passed through the selected memory cell (110s), and sensing a resistive state of the resistive memory element (112) of the selected memory cell (110s) using the sense amplifier circuitry (120, 140; 220, 240; 320, 340).

2. A method according to claim 1, wherein the memory device, subsequent to the read mode configuration, is configured to read each memory cell of the memory device in accordance with the first read scheme, or to read each memory cell of the memory device in accordance with the second read scheme.

3. A method according to any preceding claim, wherein, for at least a majority of the memory cells, a read margin is greater when read in accordance with one of the first and second read schemes than when read in accordance with the other of the first and second read schemes, and wherein the read mode configuration comprises configuring at least said majority of memory cells to be read in accordance with said one of the first and second read schemes.

4. A method according to claim 3, wherein the read mode configuration comprises configuring each memory cell to be read in accordance with said one of the first and second read schemes.

5. A method according to any one of the preceding claims, wherein the first and second read schemes each comprise applying a first access line un-select voltage to first access lines connected to non-selected memory cells and applying a second access line un-select voltage to second access lines connected to the non-selected memory cells, wherein the first access line un-select voltages of the first and second read scheme are equal and the second access line un-select voltages of the first and second read scheme are equal.

6. A method according to any one of the preceding claims, wherein the memory device further comprises control circuitry (106),

wherein the read mode configuration comprises adapting the control circuitry to control the memory device to operate such that each memory cell, when selected to be read, is read in accordance with the first or second read scheme.

7. A method according to any preceding claim, wherein the sense amplifier circuitry (120, 140) comprises a plurality of sense amplifiers, each sense amplifier connected to a respective first or second access line; or wherein the sense amplifier circuitry (220, 240; 320, 340) comprises a sense amplifier commonly connected to each first access line or each second access line.

8. A method according to any preceding claim,

wherein according to the first read scheme the first read current is sourced by a first current source (360) via the first access line (BL) connected to said selected memory cell (110s) and sunk by a first current sink (330) via the second access line (WL) connected to said selected memory cell (110s), and
wherein according to the second read scheme the second read current is sourced by a second current source (380) via the second access line (WL) connected to said selected memory cell (110s) and sunk by a second current sink (350) via the first access line (BL) connected to said selected memory cell (110s).

9. A method according to claim 8, wherein the memory device comprises a plurality of first and second current sources, each switchably connected to a respective first and second access line, respectively, and a plurality of first and second current sinks, each switchably connected to a respective second and first access line, respectively; or wherein the memory device comprises a common first and a common second current source (360, 380) switchably connected to each of the first and second access lines, respectively, and a common first and a common second current sink (230, 330) switchably connected to each of the second and first access lines, respectively.

10. A method according to any preceding claim, wherein the sense amplifier circuitry comprises a first sense amplifier circuit (120, 220) and a second sense amplifier circuit (140, 240), the first sense amplifier circuit connected to the plurality of first access lines (BL) and the second sense amplifier circuit connected to the plurality of second access lines (WL), or vice versa, and wherein:

the first read scheme further comprises sensing the resistive state of the resistive memory element (112) of the selected memory cell (110s) using the first sense amplifier circuit (120, 220), and
the second read scheme further comprises sensing the resistive state of the resistive memory element (112) of the selected memory cell (110s) using the second sense amplifier circuit (140, 240).

11. A method according to any of claims 1-9, wherein the sense amplifier circuitry comprises a sense amplifier circuit (320) connected to the plurality of first access lines (BL) or the plurality of second access lines (WL), and wherein:

the first read scheme further comprises sensing the resistive state of the resistive memory element (112) of the selected memory cell (110s) using said sense amplifier circuit (320), and
the second read scheme further comprises sensing the resistive state of the resistive memory element (112) of the selected memory cell (110s) using said sense amplifier circuit (320).

12. A memory device (100, 200, 300) comprising:

a plurality of first and second access lines, the plurality of first access lines forming a plurality of bit lines (BL) and the plurality of second access lines forming a plurality of word lines (WL), or vice versa,
a plurality of memory cells (110), wherein each memory cell comprises a resistive memory element (112) and a bipolar selector (114) connected in series between a respective pair of first and second access lines, and
a sense amplifier circuitry (120, 140; 220, 240; 320, 340) connected to the plurality of first access lines and/or the plurality of second access lines,
wherein the memory device is configured such that each memory cell, when selected to be read, is read in accordance with one of a first and a second read scheme, wherein:

the first read scheme comprises: applying a first read voltage across a selected memory cell (110s), such that a read current of a first polarity is passed through the selected memory cell (110s), and sensing a resistive state of the resistive memory element (112) of the selected memory cell (110s) using the sense amplifier circuitry (120, 140; 220, 240; 320, 340), and
the second read scheme comprises: applying a second read voltage across a selected memory cell (110s), such that a read current of a second polarity opposite to the first polarity is passed through the selected memory cell (110s), and sensing a resistive state of the resistive memory element (112) of the selected memory cell (110s) using the sense amplifier circuitry (120, 140; 220, 240; 320, 340).

13. A memory device according to claim 12,

wherein according to the first read scheme the first read current is sourced by a first current source (360) via the first access line (BL) connected to said selected memory cell (110s) and sunk by a first current sink (330) via the second access line (WL) connected to said selected memory cell (110s), and

wherein according to the second read scheme the second read current is sourced by a second current source (380) via the second access line (WL) connected to said selected memory cell (110s) and sunk by a second current sink (350) via the first access line (BL) connected to said selected memory cell (110s).

14. A memory device according to claim 12 or 13, wherein the sense amplifier circuitry comprises a first sense amplifier circuit (120, 220) and a second sense amplifier circuit (140, 240), the first sense amplifier circuit connected to the plurality of first access lines (BL) and the second sense amplifier circuit connected to the plurality of second access lines (WL), or vice versa, and wherein:

the first read scheme further comprises sensing the resistive state of the resistive memory element (112) of the selected memory cell (110s) using the first sense amplifier circuit (120, 220), and

the second read scheme further comprises sensing the resistive state of the resistive memory element (112) of the selected memory cell (110s) using the second sense amplifier circuit (140, 240).

15. A memory device according to claim 12 or 13, wherein the sense amplifier circuitry comprises a sense amplifier circuit (320) connected to the plurality of first access lines (BL) or the plurality of second access lines (WL), and wherein:

the first read scheme further comprises sensing the resistive state of the resistive memory element (112) of the selected memory cell (110s) using said sense amplifier circuit (320), and

the second read scheme further comprises sensing the resistive state of the resistive memory element (112) of the selected memory cell (110s) using said sense amplifier circuit (320).

BL

110

112

114

WL

**Fig. 1**

901
Test read performance metric

902
Perform read mode
configuration

**Fig. 9**

**Fig. 2**

Fig. 3

EP 3 772 064 A1

**Fig. 4**

EP 3 772 064 A1

**Fig. 5**

*Fig. 6*

○ Selected cell

△ Half-selected cell

✕ UN-selected cell

240 NEG_SAEN

OUT

PSINK_POS

230

NEG_DL$_{i-1}$

V$_{BL\_UNSEL}$

TR$_{i-1}$

110s

TR$_i$

110h

TR$_j$

250

PSINK_NEG

BL$_j$

Y$_j$

110h

110u

BL$_{j-1}$

Y$_{j-1}$

WL$_i$

V$_{WL\_UNSEL}$

WL$_i$

Y$_j$

OUT

220

TR$_{j-1}$

Y$_{j-1}$

PWL$_{i-1}$

PWL$_i$

POS_SAEN

200

○ Selected cell

△ Half-selected cell

✖ UN-selected cell

*Fig. 7*

**Fig. 8**

EP 3 772 064 A1

Europäisches
Patentamt

European
Patent Office

Office européen
des brevets

# EUROPEAN SEARCH REPORT

Application Number

EP 19 18 9801

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/088911 A1 (NAKURA MITSURU [JP] ET AL) 11 April 2013 (2013-04-11) | 1,2,12, 13,15 | INV.<br>G11C13/00<br>G11C11/16 |
| Y | * paragraphs [0023], [0087] - [0096], | 10,14 | |
| A | [0100], [0161] - [0166], [0172] - [0181]; figures 3, 7-10, 24, 26, 27, 28 * | 3-9,11 | |
| | ----- | | |
| Y | US 2012/182786 A1 (BAEK IN-GYU [KR] ET AL) 19 July 2012 (2012-07-19)<br>* paragraphs [0013], [0028] - [0054]; figures 1-5 * | 1-15 | |
| | ----- | | |
| Y | US 2019/027201 A1 (PETTI CHRISTOPHER [US] ET AL) 24 January 2019 (2019-01-24)<br>* paragraphs [0017] - [0020], [0034] - [0036], [0063]; figures 1, 5 * | 1-15 | |
| | ----- | | |

TECHNICAL FIELDS
SEARCHED (IPC)

G11C

The present search report has been drawn up for all claims

| Place of search | Date of completion of the search | Examiner |
|---|---|---|
| The Hague | 27 January 2020 | Vidal Verdú, Jorge |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 19 18 9801

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2020

| Patent document cited in search report | | Publication date | Patent family member(s) | | Publication date |
|---|---|---|---|---|---|
| US 2013088911 | A1 | 11-04-2013 | CN | 103035289 A | 10-04-2013 |
| | | | JP | 5642649 B2 | 17-12-2014 |
| | | | JP | 2013084324 A | 09-05-2013 |
| | | | KR | 20130038164 A | 17-04-2013 |
| | | | TW | 201329981 A | 16-07-2013 |
| | | | US | 2013088911 A1 | 11-04-2013 |
| US 2012182786 | A1 | 19-07-2012 | KR | 20120082237 A | 23-07-2012 |
| | | | US | 2012182786 A1 | 19-07-2012 |
| US 2019027201 | A1 | 24-01-2019 | KR | 20200005657 A | 15-01-2020 |
| | | | US | 2019027201 A1 | 24-01-2019 |
| | | | WO | 2019022815 A1 | 31-01-2019 |

EPO FORM P0459

For more details about this annex : see Official Journal of the European Patent Office, No. 12/82